# EUROPEAN PATENT APPLICATION

(11) **EP 4 835 132 A1**
(43) Date of publication of application: **04.11.2026**
(21) Application number: 26171205.3
(22) Date of filing: 08.04.2026
(51) Int. Cl.: C23C 16/44

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 25.04.2025 JP 2025072802
(71) Applicant: Kokusai Electric Corporation, Tokyo 100-0004 (JP)
(72) Inventor: YAMANE, Yoma, Toyama-shi, Toyama, 9392393 (JP); ISHIBASHI, Kiyohisa, Toyama-shi, Toyama, 9392393 (JP); NOHARA, Shingo, Toyama-shi, Toyama, 9392393 (JP); SUZUKI, Kento, Toyama-shi, Toyama, 9392393 (JP)
(74) Representative: Bardehle Pagenberg Partnerschaft mbB Patentanwälte Rechtsanwälte

(57) **Abstract**

There is provided a technique that includes (a) performing: (al) storing a process gas obtained by phase-changing a substance in a liquid or solid phase in a reservoir (300) at a predetermined temperature; and (a2) supplying the process gas stored in the reservoir (300) to a substrate (200); and (b) after (a), performing: (bl) supplying a purge gas into the reservoir (300) that is at a temperature higher than the predetermined temperature; and (b2) exhausting the purge gas in the reservoir (300)

## Description

### CROSS-REFERENCE TO RELATED APPLICATION

This application is based upon and claims the benefit of priority from Japanese Patent Application No. 2025-072802, filed on April 25, 2025, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of manufacturing a semiconductor device or a process of processing a substrate, a cycle including a process of supplying a gas stored in a reservoir (gas collection) to a substrate is performed, and a film is formed on a surface of the substrate in some cases.

### SUMMARY

Some embodiments of the present disclosure provides a technique capable of suppressing adhesion of a foreign substance (a particle) to a substrate.

According to some embodiments of the present disclosure, there is provided a technique that includes: (a) performing: (a1) storing a process gas obtained by phase-changing a substance in a liquid or solid phase in a reservoir at a predetermined temperature; and (a2) supplying the process gas stored in the reservoir to a substrate; and (b) after (a), performing: (b1) supplying a purge gas into the reservoir that is at a temperature higher than the predetermined temperature; and (b2) exhausting the purge gas in the reservoir.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a substrate processing apparatus suitably used in embodiments of the present disclosure, and is a diagram showing a process furnace portion in a longitudinal cross-sectional view.
FIG. 2 is a schematic configuration diagram of a controller of a substrate processing apparatus suitably used in the embodiments of the present disclosure, and is a diagram illustrating a control system of the controller in a block diagram.
FIG. 3A is a flowchart illustrating a flow of a processing process in the embodiments of the present disclosure. FIG. 3B is a flowchart illustrating a flow of a substrate processing process in the embodiments of the present disclosure. FIG. 3C is a flowchart illustrating the flow of the first process gas supply process in the embodiments of the present disclosure.
FIG. 4A is a flowchart illustrating a flow of an extraneous material removing process in the embodiments of the present disclosure. FIG. 4B is a flowchart illustrating a flow of a tank purge process in the embodiments of the present disclosure.
FIG. 5 is a diagram illustrating a schematic of a configuration of a first process gas supply system and its periphery in the embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of the Present Disclosure>

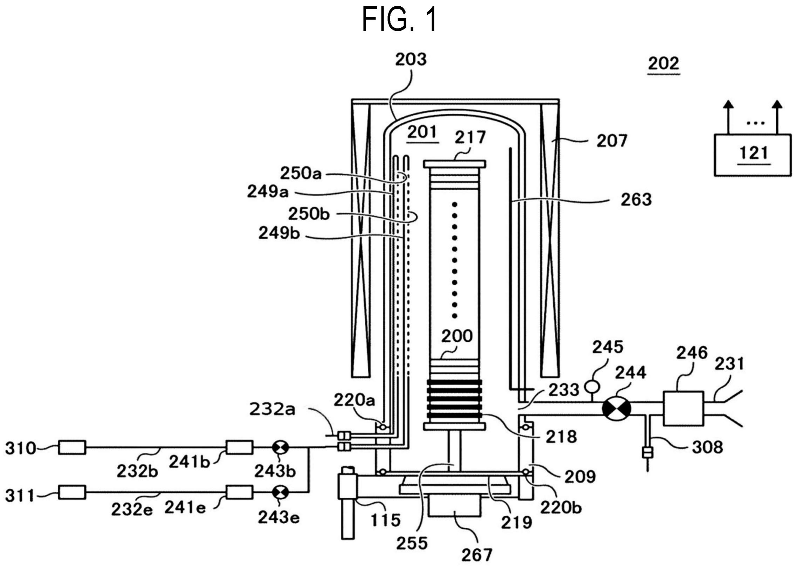

Hereinafter, embodiments of the present disclosure will be mainly described with reference to FIGS. 1, 2, 3A to 3C, and 4A, 4B, and 5. In addition, the drawings used in the following description are schematic, and the dimensional relationship of each element, the ratio of each element, and the like shown in the drawings may not be consistent with those of reality. In addition, the dimensional relationship of each element, the ratio of each element, and the like may not coincide with each other in a plurality of drawings.

### (1) Configuration of Substrate Processing Apparatus

As shown in FIG. 1, the process furnace 202 includes a heater 207 as a heating system (temperature adjuster). Inside the heater 207, a reaction tube 203 is disposed concentrically with the heater 207. The reaction tube 203 is formed in a cylindrical shape in which the upper end is closed and the lower end is opened. A manifold 209 is disposed below the reaction tube 203 in a concentric shape with the reaction tube 203. An O-ring 220a as a seal member is provided between the manifold 209 and the reaction tube 203. A process container (reaction container) is mainly configured by the reaction tube 203 and the manifold 209. A process chamber 201, which is a processing space, is formed in the hollow portion of the process container. The process chamber 201 is configured to accommodate a wafer 200 as a substrate. The wafer 200 is disposed inside the process chamber 201, and processing on the wafer 200 is performed.

In the process chamber 201, nozzles 249a and 249b are provided to penetrate the side walls of the manifold 209. Gas supply pipes (pipes) 232a and 232b are connected to the nozzles 249a and 249b, respectively.

The nozzles 249a and 249b are provided so as to extend upward in the annular space in a plan view between the inner wall of the reaction tube 203 and the wafer 200 along the inner wall of the reaction tube 203 from the lower portion to the upper portion thereof, respectively, toward the upper side in the stacking direction of the wafer 200. On the side surfaces of the nozzles 249a and 249b, gas supply holes 250a and 250b, which are supply ports for supplying gas, are provided, respectively. A plurality of gas supply holes 250a and 250b are provided from the lower portion to the upper portion of the reaction tube 203.

A seal cap 219 is provided below the manifold 209 which is capable of clogging the lower end opening of the manifold 209 in an airtight manner. On the upper surface of the seal cap 219, an O-ring 220b as a seal member abutting the lower end of the manifold 209 is provided. Below the seal cap 219, a boat 217 to be described later and a rotator 267 for rotating the wafer 200 supported by the boat 217 are provided via a rotation shaft 255. The boat elevator 115 is configured as a conveyance apparatus (conveyance mechanism) that loads and unloads the boat 217 and the wafer 200 into and out of the process chamber 201 by raising and lowering the seal cap 219.

The boat 217 serving as a substrate support port is configured to support a plurality of wafers 200, for example, 25 to 200 wafers, in a horizontal posture and in multiple stages by aligning them in a vertical direction in a state in which the centers are aligned with each other. In the lower part of the boat 217, the insulating plate 218 is supported in multiple stages. Note that the notation of a numerical range such as "25 to 200 wafers" in this specification means that a lower limit value and an upper limit value are included in the range. Thus, for example, "25 to 200 wafers" means "25 or more and 200 wafers or less." The same is true for other numerical ranges.

A temperature sensor 263 as a temperature detector is provided in the reaction tube 203. By adjusting the energization state of the heater 207 based on the temperature information detected by the temperature sensor 263, the temperature in the process chamber 201 becomes a desired temperature distribution.

Next, details of the gas supply system and the exhaust system will be described.

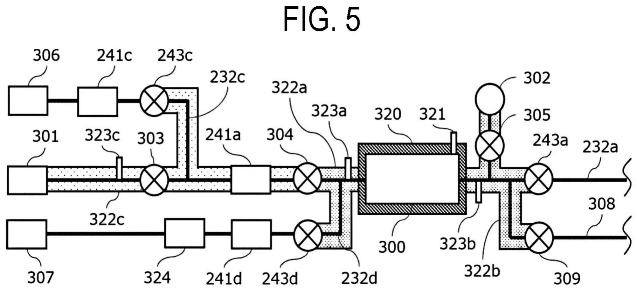

As shown in FIG. 5, the gas supply pipe 232a is provided with, in turn from the upstream direction, a first source 301 serving as a process gas source that supplies the first process gas, a valve 303 serving as an open/close valve, a mass flow controller (MFC) 241a serving as a flow controller (flow control portion), a valve 304, a tank 300 serving as an example of a reservoir that stores gas therein, a pressure sensor 302 serving as a pressure meter that measures pressure, and a valve 243a. The reservoir may be configured as a spiral pipe or the like. The pressure sensor 302 is configured to detect a pressure in the gas supply pipe 232a between the tank 300 and the valve 243a. The pressure sensor 302 is provided with a valve 305 that blocks and opens the flow of gas inside the pressure sensor 302.

The reservoir may be configured as a spiral pipe or the like. Further, the tank 300 may be omitted, and a section between the valves 304, 243a, 243d, and 309 among the gas supply pipes 232a, 232d, and the gas exhaust pipe 308 may be regarded as a reservoir, and a gas may be stored in the section. The tank 300 is preferably configured to have a larger volume per unit length than a flow path (gas supply pipes 232a, 232d, and gas exhaust pipes 308 in this embodiment) connected to the tank 300.

The first source 301 supplies, as the first process gas, a gas which that may undergo a phase-change to a liquid phase or a solid phase due to a decrease in temperature until it is supplied into the process chamber 201. For example, the first process gas is a gas obtained by phase-changing a liquid or solid substance at normal temperature and normal pressure. The first process gas is, for example, a precursor gas, and is a process gas exhibiting a chemical action on the wafer 200 or in the process chamber 201. Further, as the first source 301, a vaporizer or the like may be used, or an introduction port of the first process gas supplied from the outside of the substrate processing apparatus may be used.

A gas supply pipe 232c is connected between the valve 303 and the MFC 241a of the gas supply pipe 232a. Further, a gas supply pipe 232d is connected between the valve 304 and the tank 300 of the gas supply pipe 232a. In the gas supply pipe 232c, the second source 306, the MFC 241c, and the valve 243c are provided in turn from the upstream direction, respectively. In the gas supply pipe 232d, in turn from the upstream direction, a third source 307, a heater 324 serving as a gas heating part that heats a gas passing through the inside, an MFC 241d, and a valve 243d are provided, respectively. In addition, among the gas supply pipe 232d, a heater for adjusting the temperature in the section between the third source 307 and the valve 243d may be further provided, and the heater may be replaced with the heater 324.

The second source 306 and the third source 307 are each a gas source that supplies an inert gas. The second source 306 and the third source 307 may be used in common. The inert gas supplied from the second source 306 and the third source 307 acts as a purge gas that purges a gas staying in the reaction tube 203 or as a carrier gas of the first process gas in a substrate processing process to be described later. Further, in step S6, which will be described later, the gas and particles present in the gas supply pipe 232a, the MFC 241a, the tank 300, the pressure sensor 302, and the like act as a purge gas for removing particles. Thus, at least one selected from the group of the second source 306 and the third source 307 may be regarded as a purge gas source.

A gas exhaust pipe 308 is connected between the tank 300 and the valve 243a of the gas supply pipe 232a. A valve 309 is provided in the gas exhaust pipe 308. A downstream end of the gas exhaust pipe 308 is connected to an exhaust pipe 231 to be described later. The gas exhaust pipe 308 is configured to be able to discharge the gas in the gas supply pipe 232a out of the process chamber 201 through a path that does not pass through the process chamber 201 by opening and closing the valve 309.

A first process gas supply system (also referred to as a precursor gas supply system) is mainly configured by the gas supply pipe 232a, the valve 303, the MFC 241a, the valve 304, the tank 300, and the valve 243a. A first source 301, a pressure sensor 302, and a valve 305 may be included in the first process gas supply system. Further, the first inert gas supply system is mainly configured by the gas supply pipe 232c, the MFC 241c, and the valve 243c. A second source 306 may be included in the first inert gas supply system. Further, the second inert gas supply system is mainly constituted by the gas supply pipe 232d, the heater 324, the MFC 241d, and the valve 243d. The third source 307 may be included in the second inert gas supply system. Note that the first inert gas supply system and the second inert gas supply system may be referred to as an inert gas supply system. Further, an inert gas supply system may be included in the first process gas supply system. Further, the first process gas exhaust system is mainly configured by the gas exhaust pipe 308 and the valve 309. The first process gas exhaust system may be included in the first process gas supply system. It can be said that the first process gas supply system is configured to control gas flow between the first source, the second source, the third source, the process chamber 201, and the exhaust system, and the tank 300. Further, at least one selected from the group of the first process gas supply system and the second process gas supply system may be simply referred to as a process gas supply system.

In the tank 300, a heater 320, which is a first heating unit that heats the tank 300, and a temperature sensor 321, which is a temperature measuring unit (temperature measuring unit) that measures the temperature of the tank 300, are provided. In addition, among the gas supply pipes 232a and 232d, a heater 322a, which is a second heating unit that heats the first storage region, and a temperature sensor 323a, which is a temperature measuring unit that measures the temperature of the first storage region, are provided in a section between the valves 304 and 243d and the tank 300 (hereinafter referred to as a first storage region). In addition, among the gas supply pipe 232a, the pipe connecting the gas supply pipe 232a and the pressure sensor 302, and the gas exhaust pipe 308, the heater 322b, which is a third heating unit that heats the second storage region, and the temperature sensor 323b, which is a temperature measuring unit that measures the temperature of the second storage region, are provided in a section between the tank 300, the pressure sensor 302, and the valves 243a and 309 (hereinafter, referred to as a second storage region). Hereinafter, the first storage region, the tank 300, and the second storage region are integrated as a storage region. In addition, among the gas supply pipes 232a and 232c, a heater 322c, which is a fourth heating unit that heats the supply region, and a temperature sensor 323c, which is a temperature measuring unit that measures the temperature of the supply region, are provided in a section (hereinafter referred to as a supply region) between the first source 301, the valves 304 and 243c.

A first temperature control system configured to control the temperature of the tank 300 is mainly configured by the heater 320. The temperature sensor 321 may be included in the first temperature control system. By the heaters 322a and 322b, a second temperature control system is mainly configured to control the temperature of the storage region. The temperature sensors 323a and 323b may be included in the second temperature control system. By the heater 322c, a third temperature control system is mainly configured to control the temperature of the supply region. The temperature sensor 323c may be included in the third temperature control system.

In the first process gas supply system, the first inert gas supply system, and the first process gas exhaust system, an unshown heater and a temperature sensor may be further provided. The heaters 320, 322a to 322c, and 324, and heaters not shown, and the temperature sensors 321, 323a to 323c, and temperature sensors not shown may be part of at least one selected from the group of the first process gas supply system, the first inert gas supply system, and the first process gas exhaust system.

As shown in FIG. 1, the gas supply pipe 232b is provided with the fourth source 310, the MFC 241b, and the valve 243b in turn from the upstream direction.

The fourth source 310 is a gas source that supplies the second process gas. The second process gas is a reaction gas or a reforming gas that reacts with the first process gas, and is one of the process gases.

A gas supply pipe 232e is connected to the downstream side of the valve 243b of the gas supply pipe 232b. In the gas supply pipe 232e, a fifth source 311, an MFC 241e, and a valve 243e are provided in turn from the upstream direction.

The fifth source 311 is a gas source that supplies an inert gas. The inert gas supplied from the fifth source 311 acts as a purge gas or a carrier gas of the second process gas that purges a gas that stays in the reaction tube 203 in a substrate processing process to be described later.

A second process gas supply system (also referred to as a reaction gas supply system, a reformed gas supply system) is mainly configured by the gas supply pipe 232b, the MFC 241b, and the valve 243b. A fourth source 310 may be included in the second process gas supply system. Further, a third inert gas supply system is mainly configured by the gas supply pipe 232e, the MFC 241e, and the valve 243e. The fifth source 311 may be included in the third inert gas supply system. A third inert gas supply system may be included in the second process gas supply system.

In the reaction tube 203, an exhaust pipe 231 for exhausting the atmosphere in the process chamber 201 is provided. A vacuum pump 246 as a vacuum exhauster is connected to the exhaust pipe 231 via a pressure sensor 245 as a pressure detector (pressure detection unit) for detecting a pressure in the process chamber 201 and an APC (Auto Pressure Controller) valve 244 as a pressure regulator (pressure regulating unit). The APC valve 244 can perform vacuum exhaustion and vacuum exhaustion stop in the process chamber 201 by opening and closing the valve in a state in which the vacuum pump 246 is operated. Further, it is configured to be able to regulate the pressure in the process chamber 201 by adjusting the valve opening degree based on the pressure information detected by the pressure sensor 245 in a state in which the vacuum pump 246 is operated. The exhaust system is mainly configured by the exhaust pipe 231, the APC valve 244, and the pressure sensor 245. The vacuum pump 246 may be included in the exhaust system.

The above-described gas exhaust pipe 308 is connected between the APC valve 244 and the vacuum pump 246 of the exhaust pipe 231. The gas exhaust pipe 308 closes the APC valve 244 and opens and closes the valve 309 in a state in which the vacuum pump 246 is operated, whereby vacuum exhaust and vacuum exhaust stop in the gas supply pipe 232a can be performed. Further, it is configured to be able to regulate the pressure in the gas supply pipe 232a by adjusting the valve opening degree of the valve 309 based on the pressure information detected by the pressure sensor 302 in a state in which the vacuum pump 246 is operated.

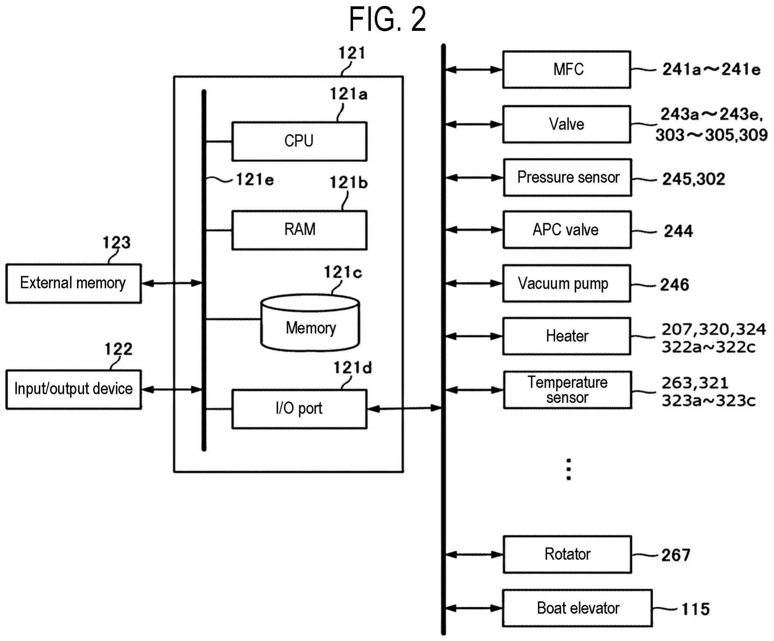

As shown in FIG. 2, the controller 121 as a controller (control means) is configured as a computer including a CPU (Central Processing Unit) 121a, a RAM (Random Access Memory) 121b, a memory 121c, and an I/O port 121d. The RAM 121b, the memory 121c, and the I/O port 121d are configured to be capable of data exchange with the CPU 121a via the internal bus 121e. An input/output device 122 configured as, for example, a touch panel or the like is connected to the controller 121.

The memory 121c is configured of, for example, a flash memory, an HDD (Hard Disk Drive), an SSD (Solid State Drive), or the like. In the memory 121c, a control program for controlling the operation of the substrate processing apparatus, a process recipe in which a procedure, a condition, or the like of a film formation process described later is described, or the like is recorded and stored so as to be readable. The process recipe is a combination in which each order in the film formation process described later is executed by the controller 121 to obtain a predetermined result, and functions as a program. Hereinafter, a process recipe, a control program, or the like is collectively referred to as a program (program product). Further, the process recipe is simply referred to as a recipe. In the present specification, the case where the word "program" is used includes solely a recipe group, solely a control program group, or both of them in some cases. The RAM 121b is configured as a memory area (work area) in which programs, data, and the like read by the CPU 121a are temporarily held.

The I/O port 121d is connected to the above-described MFCs 241a to 241e, valves 243a to 243e, 303 to 305, 309, pressure sensors 245, 302, APC valves 244, vacuum pumps 246, heaters 207, 320, 322a to 322c, 324, temperature sensors 263, 321, 323a to 323c, a rotator 267, a boat elevator 115, and the like.

The CPU 121a is configured to read and execute a control program from the memory 121c and read a recipe from the memory 121c in accordance with an input of an operation command from the input/output device 122 or the like. The CPU 121a is configured to be able to control a flow rate regulating operation of various gases by the MFCs 241a to 241e, an opening-closing operation of the valves 243a to 243e, 303 to 305, and 309, an opening-closing operation of the APC valve 244 and a pressure regulating operation by the APC valve 244 based on the pressure sensors 245 and 302, a start-up and stop of the vacuum pump 246, a temperature regulating operation of the heater 207 based on the temperature sensor 263, a rotation and rotation speed adjustment operation of the boat 217 by the rotator 267, an elevation operation of the boat 217 by the boat elevator 115, and the like so as to comply with the contents of the read recipe.

The controller 121 can be configured by installing the above-described program which is recorded in an external memory (for example, a magnetic disk such as a hard disk, an optical disk such as a CD, or a semiconductor memory such as a USB memory) 123 and stored in a computer. The memory 121c or the external memory 123 is configured as a computer-readable recording medium; hereinafter, they are collectively referred to simply as recording media. In the present specification, the case where the word "recording medium" is used includes solely the memory 121c, solely the external memory 123, or both of them in some cases. Further, the provision of the program to the computer may be performed using a communication means such as the Internet or a dedicated line without using the external memory 123.

### (2) Processing Process

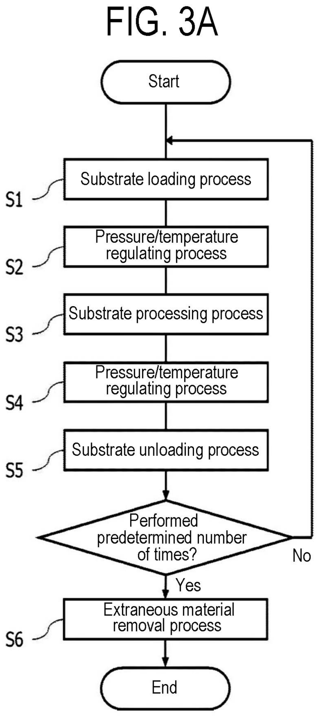

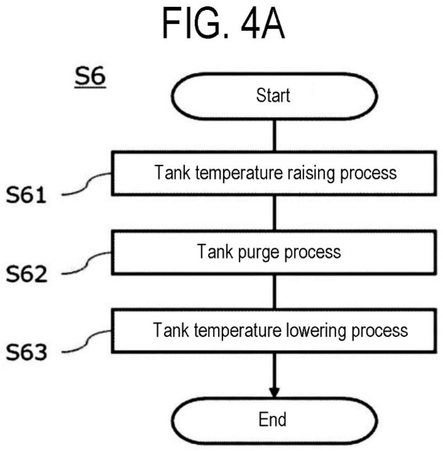

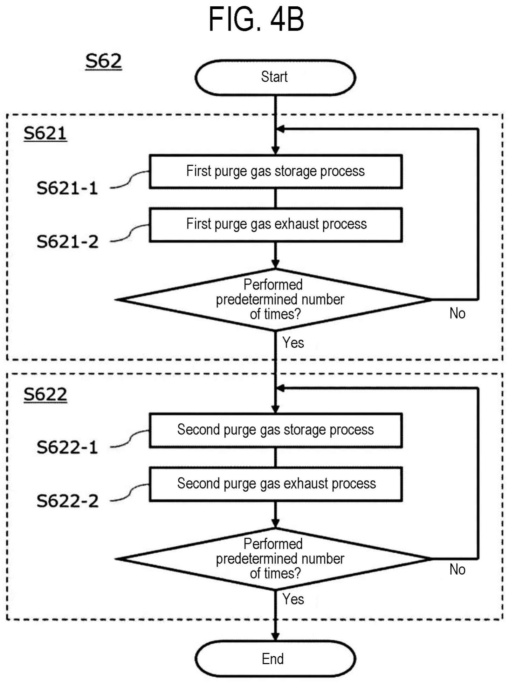

Next, as a semiconductor manufacturing step, a processing step of performing the substrate processing step using the above-described substrate processing apparatus and then the step of removing the extraneous material in the reservoir will be described using FIGS. 3A to 3C and FIGS. 4A and 4B. In the following description, the operation of each unit constituting the substrate processing apparatus is controlled by the controller 121. As shown in FIG. 3A, in the processing process, steps S1 to S6 are performed. Further, after step S6, steps S1 to S6 may also be performed.

The term "wafer" used in this specification may refer to the wafer itself or may refer to a stack of the wafer and a predetermined layer or film formed on the surface thereof. The term "surface of a wafer" used in this specification may refer to a surface of the wafer itself or may refer to a surface such as a predetermined layer formed on the wafer. In this specification, the case where "forming a predetermined layer on a wafer" means directly forming a predetermined layer on the surface of the wafer itself, or in some cases, forming a predetermined layer on a layer formed on the wafer or the like. In this specification, the case where the word "substrate" is used is synonymous with the case where the word "wafer" is used.

### (Substrate Loading Process, Step S1)

When the plurality of wafers 200 are loaded into the boat 217, as shown in FIG. 1, the boat 217 supporting the plurality of wafers 200 is lifted by the boat elevator 115 and loaded into the process chamber 201.

### (Temperature/Pressure Regulating Process, Step S2)

Vacuum exhaust (depressurization exhaust) is performed by the vacuum pump 246 so that the space in the process chamber 201, i.e., where the wafer 200 exists, becomes a desired pressure (vacuum degree). At this time, the pressure in the process chamber 201 is measured with the pressure sensor 245, and the APC valve 244 is feedback controlled based on the measured pressure information. The vacuum pump 246 is continuously operated at least until the processing on the wafer 200 is finished. Further, the output of the heaters 207, 320, 322a to 322b is feedback controlled based on the temperature information detected by the temperature sensors 263, 321, 323a to 323b, so that the temperature of the tank 300, the storage region, and the supply region in the process chamber 201 is controlled to a desired temperature (temperature control). Their temperature control is continuously performed during steps S1 to S6. Hereinafter, in steps S1 to S5, a case where the temperature of the tank 300 and the storage region is controlled to a predetermined temperature will be described as an example. Further, rotation of the boat 217 and the wafer 200 by the rotator 267 is started. The rotation of the boat 217 and the wafer 200 by the rotator 267 is continuously performed between at least until the processing on the wafer 200 is finished.

### (Substrate Processing Process, Step S3)

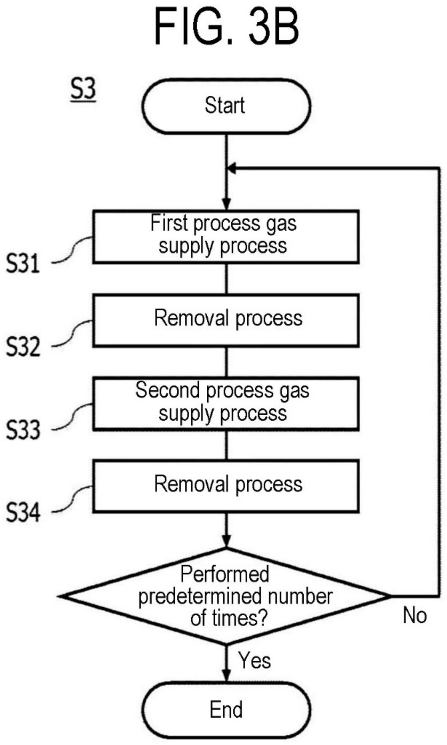

In step S3, as shown in FIG. 3B, the following cycles including steps S31 to S34 are performed a predetermined number of times.

### [First Process Gas Supply Process, Step S31]

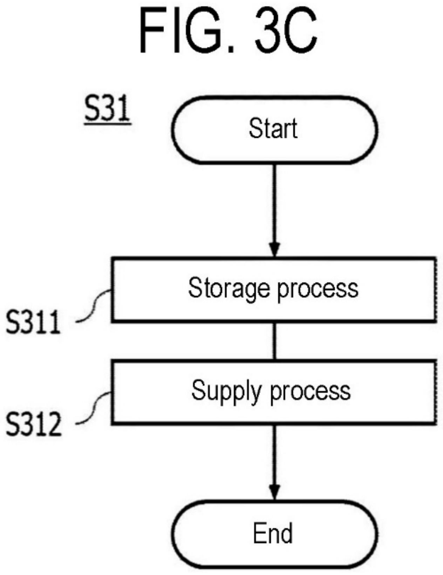

In step S31, as shown in FIG. 3C, steps S311 and S312 are performed to supply the first process gas to the wafer 200 in the process chamber 201.

### <<Storage Process, Step S311>>

In step S311, the first process gas is stored in the reservoir (or in the storage region) at a predetermined temperature. Specifically, by closing the valves 243a and 309 in advance and opening the valves 303 and 304, the first process gas regulated in flow rate by the MFC 241a is stored in the tank 300. In other words, the first process gas is boosted in the tank 300.

### <<Supply Process, Step S312>>

In step S312, the first process gas stored in the reservoir (or in the storage region) is supplied to the wafer 200. Specifically, by closing the valve 304 to open the valve 243a, the first process gas stored in the tank 300 is supplied in large quantities at a time to the wafer 200 in the process chamber 201 via the nozzle 249a, and is exhausted from the exhaust pipe 231. At this time, a first layer constituted by at least a part of the molecular structure of the first process gas is formed on the wafer 200.

As in step S31, by supplying the first process gas, the partial pressure of the first process gas in the process chamber 201 can be increased within a short time. This makes it easy to supply an amount of the first process gas that can also sufficiently treat the entire surface of the wafer 200 uniformly. Further, in the case where step S3 is performed under the condition that the first process gas is pyrolyzed in the process chamber 201, the first process gas before the pyrolysis is easily supplied uniformly to the entire surface of the wafer 200. Thereby, the influence on the processing result by the decomposition product (for example, a locally thick film is formed on the wafer 200, or the like) can be suppressed.

In step S31, in order to prevent the entry of the first process gas into the nozzle 249b, the valve 243e is opened to flow the inert gas into the gas supply pipe 232e. The inert gas is supplied into the process chamber 201 via the gas supply pipe 232e and the nozzle 249b, and is exhausted from the exhaust pipe 231. At least partially at the same time as step S31, in a state in which the valve 305 is opened, the pressure in the storage region (which may be referred to as the pressure in the tank 300) is measured using the pressure sensor 302.

As the first process gas, for example, a certain element-containing gas containing a certain element such as tungsten (W), titanium (Ti), molybdenum (Mo), tantalum (Ta), cobalt (Co), yttrium (Y), ruthenium (Ru), hafnium (Hf), zirconium (Zr), aluminum (Al), silicon (Si), or the like can be used. In this case, a layer containing a certain element as the first layer can be formed on the substrate S. As the first process gas, one or more of these may be used. As the first process gas, a gas in which these gases are activated by plasma or the like may be used.

As the predetermined element-containing gas, for example, a halogen-based predetermined element-containing gas including a predetermined element and a halogen element can be used. As the halogen-based predetermined element-containing gas, for example, a gas containing hexachlorotungsten (WCl₆), hexafluorotungsten (WF₆), titanium tetrachloride (TiCl₄), titanium tetrafluoride (TiF₄), molybdenum pentachloride (MoCl₅), molybdenum pentafluoride (MoF₅), molybdenum dichlorodioxide (MoO₂Cl₂), molybdenum tetrachloride (MoOCl₄), tantalum pentachloride (TaCl₅), tantalum pentafluoride (TaF₅), cobalt difluoride (CoF₂), cobalt dichloride (CoCl₂), yttrium trifluoride (YF₃), yttrium trichloride (YCl₃), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), dichlorosilane (SiH₂Cl₂), 1,2-dichlorodisilane (Si₂H₄Cl₂), 1,1,1-trichlorodisilane (Si₂H₃Cl₃), 1,1,2-trichlorodisilane (Si₂H₃Cl₃), pentachlorodisilane (Si₂HCl₅), hexachlorodisilane (Si₂Cl₆), tetrafluorosilane (SiF₄), and the like can be used. Further, as the predetermined element-containing gas, for example, a gas including monosilane (SiH₄), disilane (Si₂H₆), trisilane (Si₃H₈), tetrasilane (Si₄H₁₀), or the like can be used. As the predetermined element-containing gas, one or more of these may be used.

Further, as the predetermined element-containing gas, an organic-based predetermined element-containing gas containing a predetermined element and an organic ligand can be used, for example. As the organic-based predetermined element-containing gas, for example, a gas containing hexadimethylaminoditungsten (W₂[N(CH₃)₂]₆), bis(tertbutylimido)bis(dimethylamido)tungsten ((t-C₄H₉N=)₂W(N(CH₃)₂)₂), tetrakis(ethylmethylamino)titanium (Ti[N(C₂H₅)(CH₃)]₄), bis(ethylcyclopentadienyl)ruthenium (Ru(EtCp)₂), bis(cyclopentadienyl)ruthenium (Ru(Cp)₂), tetrakis(ethylmethylamino)hafnium (Hf[N(Me)Et]₄), tetrakis(diethylamino)hafnium (Hf[N(Et)₂]₄), tetrakis(dimethylamino)hafnium (Hf[N(Me)₂]₄), tris(dimethylamino)cyclopentadienylhafnium ((Cp)Hf[N(Me)₂]₃), tetrakis(ethylmethylamino)zirconium (Zr[N(Me)Et]₄), tetrakis(diethylamino)zirconium (Zr[N(Et)₂]₄), tetrakis(dimethylamino)zirconium (Zr[N(Me)₂]₄), tris(dimethylamino)cyclopentadienylzirconium ((Cp)Zr[N(Me)₂]₃), trimethylaluminum (Al(CH₃)₃), tris(dimethylamino)silane (Si[N(CH₃)₂]₃H), and the like can be used. As the predetermined element-containing gas, one or more of these may be used.

As the inert gas, for example, a nitrogen (N₂) gas or a rare gas such as argon (Ar), helium (He), neon (Ne), and xenon (Xe) can be used. As the inert gas, one or more of these may be used.

### [Removal Process, Step S32]

After the first layer including the predetermined element is formed on at least a part of the wafer 200, the valve 243a is closed, and the supply of the first process gas is stopped. At this time, the APC valve 244 is fully opened, and the inside of the process chamber 201 is vacuum-exhausted by the vacuum pump 246, and an unreacted first process gas remaining in the process chamber 201 or a reaction product generated by a reaction of the first process gas with the surface of the wafer 200 is removed from the inside of the process chamber 201. At this time, the valves 243c to 243e remain open to maintain the supply of the inert gas into the process chamber 201. The inert gas acts as a purge gas.

### [Second Process Gas Supply Process, Step S33]

Next, a second process gas, which reacts with the first layer that is a surface (which may also be referred to as a top surface) of the wafer 200, is supplied to the wafer 200 in the process chamber 201. Specifically, the valve 243b is opened to flow the second process gas into the gas supply pipe 232b. The second process gas is regulated in flow rate by the MFC 241b to be supplied into the process chamber 201 via the nozzle 249b, and is exhausted from the exhaust pipe 231. At this time, the valve 243e is opened at the same time to flow an inert gas into the gas supply pipe 232e. The inert gas is regulated in flow rate by the MFC 241e to be supplied into the process chamber 201 together with the second process gas, and is exhausted from the exhaust pipe 231. Further, in order to prevent entry of the second process gas into the nozzle 249a, the valve 243a is opened to flow an inert gas into the gas supply pipe 232a. The inert gas is supplied into the process chamber 201 via the gas supply pipe 232c and/or the gas supply pipe 232d and the nozzle 249a, and is exhausted from the exhaust pipe 231.

By supplying the second process gas to the wafer 200 under the above-described conditions, at least a part of the first layer formed on the wafer 200 is modified, thereby the second layer is formed on the wafer 200.

As the second process gas, for example, a gas including a reducing gas, an oxidizing gas, a nitriding gas, a sulfiding gas, a selenizing gas, a tellurizing gas, or the like can be used. As the second process gas, one or more of these may be used. As the second process gas, a gas in which these gases are activated by plasma or the like may be used.

For example, in the case where the first process gas is used as a predetermined element-containing gas and the second process gas is used as a reducing gas, as the second layer, a layer constituted from a single predetermined element can be formed on the wafer 200. Further, for example, in the case where the first process gas is a predetermined element-containing gas and the second process gas is any one of an oxidizing gas, a nitriding gas, a sulfiding gas, a selenizing gas, and a tellururizing gas, as the second layer, an oxide layer of a predetermined element, a nitride layer of a predetermined element, a sulfide layer of a predetermined element, a selenide layer of a predetermined element, and a tellururide layer of a predetermined element can be formed on the wafer 200.

As the reducing gas, for example, one or more of a gas including hydrogen (H₂) gas, deuterium (D₂) gas, borane (BH₃) gas, diborane (B₂H₆) gas, carbon monoxide (CO) gas, ammonia (NH₃) gas, monosilane (SiH₄) gas, disilane (Si₂H₆) gas, trisilane (Si₃H₈) gas, monogermane (GeH₄) gas, digermane (Ge₂H₆), and the like can be used. As the oxidizing gas, for example, one or more of a gas including oxygen (O₂), ozone (O₃), water vapor (H₂O), a mixed gas of H₂ and O₂, hydrogen peroxide (H₂O₂), nitrous oxide (N₂O), and the like can be used. As the nitriding gas, for example, one or more of a hydrogen nitride-based gas such as ammonia (NH₃) gas, diazene (N₂H₂) gas, hydrazine (N₂H₄) gas, and N₃H₈ gas can be used. As the sulfiding gas, for example, a gas including sulfane (H₂S), disulfane (H₂S₂), diammonium sulfide ((NH₄)₂S), dimethyl sulfide ((CH₃)₂S), or the like can be used. As the sulfiding gas, one or more of these may be used. As the selenizing gas, for example, a gas including selane (H₂Se), diselane (H₂Se₂), dimethylselenide ((CH₃)₂Se), or the like can be used. As the selenizing gas, one or more of these may be used. As the tellurizing gas, for example, a gas including tellane (H₂Te), ditellane (H₂Te₂), dimethyltellane ((CH₃)₂Te), or the like can be used. As the tellurizing gas, one or more of these may be used.

### [Removal Process, Step S34]

After at least a portion of the first layer on the wafer 200 is modified into the second layer, the valve 243b is closed to stop supply of the second process gas. At this time, the gas in the process chamber 201 is removed from the inside of the process chamber 201 by vacuum exhausting the inside of the process chamber 201. Step S34 is performed in the same order as in step S32.

### (Performing Predetermined Number of Times)

The cycle including steps S31 to S34 described above is performed a predetermined number of times (n1 times, where n1 is an integer of 1 or 2 or more). Thereby, a film including a predetermined element having a predetermined thickness is formed on the wafer 200. For example, as a film, a film composed of a single predetermined element, an oxide film of a predetermined element, a nitride film of a predetermined element, a sulfide film of a predetermined element, a selenide film of a predetermined element, and a telluride film of a predetermined element can be formed on the wafer 200.

### (Pressure/Temperature Regulating Process, Step S4)

An inert gas is supplied into the process chamber 201 from each of the gas supply pipes 232c to 232e, and is exhausted from the exhaust pipe 231. Thereby, the process chamber 201 is purged, and then, the atmosphere in the process chamber 201 is replaced with an inert gas, and the pressure in the process chamber 201 is returned to the atmospheric pressure.

### (Substrate Unloading Process, Step S5)

The seal cap 219 is lowered by the boat elevator 115 to open the bottom of the manifold 209. Then, in a state in which the wafer 200 that has been processed is supported by the boat 217, the wafer 200 is unloaded from the lower end of the manifold 209 to the outside of the reaction tube 203, which is out of the process chamber 201. The wafer 200 that has been processed is taken out from the boat 217.

### (Performing Predetermined Number of Times)

The cycle including steps S1 to S5 described above is performed a predetermined number of times (n2 times, where n2 is an integer of 1 or 2 or more).

### (Extraneous Material Removal Process, Step S6)

An extraneous material removal process (step S6) is performed, and the extraneous material in the first process gas supply system is removed. Hereinafter, an example of step S6 will be described using FIGS. 4A and 4B. In step S6, as shown in FIG. 4A, the tank temperature raising process (step S61), the tank purging process (step S62), and the tank temperature lowering process (step S63) are sequentially performed. Further, step S61 may be performed at the same time as steps S4 and S5.

### [Tank Temperature Raising Process, Step S61]

The temperature of the tank 300 is set to a temperature higher than a predetermined temperature (the temperature of the tank 300 in steps S1 to S5). At this time, it is preferable that the temperature of the storage region including the tank 300 be higher than the predetermined temperature. Specifically, the electric power supplied to the heater 320 is feedback-controlled based on the temperature information detected by the temperature sensor 321 so that the tank 300 and the storage region are at a temperature higher than the predetermined temperature. This temperature control is continuously performed at least until the tank purge process S62 ends.

### [Tank Purge Process, Step S62]

In step S62, supplying a purge gas into the tank 300 at a second temperature higher than a first temperature and exhausting the purge gas in the tank 300 are performed. Hereinafter, as an example of step S62, the case where the first purge process S621 and the second purge process S622 are sequentially performed as shown in FIG. 4B will be described as an example.

### <<First Purge Process, Step S621>>

In step S621, as shown in FIG. 4B, a first purge gas storage process S621-1 and a first purge gas exhaust process S621-2 are performed. Specifically, the purge gas stored in the tank 300, and the purge gas stored in the tank 300 is exhausted through a path that does not pass through the process chamber 201.

### [First Purge Gas Storage Process, Step S621-1]

In step S621-1, the purge gas supplied into the tank 300 is stored in the tank 300. Specifically, by opening the valves 243c and 243d, an inert gas as a purge gas regulated in flow rate by the MFCs 241c and 241d is supplied into the tank 300. At this time, by closing the valves 243a, 309 and 303 in advance, the purge gas supplied into the tank 300 can be stored in the tank 300. In other words, the purge gas is boosted in the tank 300. Further, in Step S621-1 and Step S621-2 to be described later, for example, the heater 324 is used to heat at least a part of the flow path that supplies the purge gas into the tank 300.

A processing condition of step S621-1 is exemplified as follows:
Process time: 1 to 30 seconds, specifically 5 to 25 seconds; and
Flow rate of the purge gas supplied into the tank 300: 0.1 to 2.0 slm, desirably 0.5 to 1.5 slm.

### [First Purge Gas Exhaust Process, Step S621-2]

In step S621-2, the purge gas stored in the tank 300 is exhausted through a path that does not pass through the process chamber 201. Specifically, by closing the valves 304, 243a, and 243d and opening the valve 309, the purge gas stored in the tank 300 is exhausted by the vacuum pump 246 via the gas exhaust pipe 308. That is, in step S621-2, the purge gas in the tank 300 is exhausted through a path that does not pass through the space in which the wafer 200 is disposed in step S3.

A processing condition of step S621-2 is exemplified as follows:
Process time: 1 to 30 seconds, specifically 5 to 25 seconds.

### (Performing Predetermined Number of Times)

The cycle including the above-described steps S621-1 and S621-2 is performed a predetermined number of times (n3 times, n3 is an integer of 1 or 2 or more). For example, n3 is 1 to 1000, specifically 10 to 800.

### <<Second Purge Process, Step S622>>

In step S622, as shown in FIG. 4B, the second purge gas storage process S622-1 and the second purge gas exhaust process S622-2 are performed. Specifically, the purge gas stored in the tank 300, and the purge gas stored in the tank 300 is exhausted through a path that passes through the process chamber 201.

### [Second Purge Gas Storage Process, Step S622-1]

In step S622-1, the purge gas supplied into the tank 300 is stored in the tank 300. Step S622-1 is performed in the same procedure and processing conditions as in step S621-1, for example.

### [Second Purge Gas Exhaust Process, Step S622-2]

In step S622-2, the purge gas stored in the tank 300 is exhausted through a path that through the process chamber 201. Specifically, by closing the valves 304, 309, and 243d and opening the valve 243a, the purge gas stored in the tank 300 is supplied into the process chamber 201, and is exhausted by the vacuum pump 246 via the exhaust pipe 231. That is, in step S622-2, the purge gas in the tank 300 is exhausted through a path that passes through a space in which the wafer 200 is disposed in step S3.

A processing condition of step S622-2 is exemplified as follows:
Process time: 1 to 30 seconds, specifically 5 to 25 seconds.

### (Performing Predetermined Number of Times)

The cycle including the above-described steps S622-1 and S622-2 is performed a predetermined number of times (n4 times, n4 is an integer of 1 or 2 or more).

### [Tank Temperature Lowering Process, Step S63]

The temperature of the tank 300 and the storage region is set to a predetermined temperature. Specifically, the electric power supplied to the heater 320 is feedback controlled based on the temperature information detected by the temperature sensor 321 so that the tank 300 and the storage region are at a predetermined temperature.

According to the embodiments, in addition to the above-described effects, one or a plurality of effects shown below are obtained.
(a) In the case where the wafer 200 is processed using a gas obtained by phase-changing a liquid or solid substance, such as the above-described first process gas, the first process gas is liquefied or solidified (phase-change) in the first process gas supply system, and adheres to the inner wall of the first process gas supply system in some cases. In some cases, these extraneous materials are peeled off from the inner wall of the first process gas supply system by the flow of gas passing through the first process gas supply system, and is conveyed into the process chamber 201 or on the wafer 200, and becomes particles.

In particular, in the substrate processing using the reservoir as in the present embodiment, a large amount of the first process gas which is boosted in the reservoir (or in the supply region) moves from within the reservoir toward the inside of the process chamber 201 within a short time. Therefore, the extraneous material in the reservoir or in the storage region is particularly easy to be conveyed in the process chamber 201 or on the wafer 200. Therefore, there are cases where particle generation cannot be sufficiently suppressed by simply applying the means for removing the extraneous material in the substrate processing apparatus that does not use the reservoir such as the tank 300.

In these embodiments, after step S3, a step S6, that is, a step including supplying a purge gas into the tank 300 at a second temperature higher than the first temperature, and exhausting the purge gas in the tank 300 is performed. As a result, it is possible to promote discharge out of the first process gas supply system because it causes the extraneous material in the tank 300 originating from liquefaction or solidification to phase change into the gas phase. Thus, the adhesion of particles to the wafer 200 can be suppressed.

(b) In these embodiments, in the first purge process S621 and the second purge process S622, the purge gas is stored in the tank 300 (reservoir), and then the purge gas stored in the tank 300 is exhausted. Thereby, at least one of the following effects can be obtained.

(b1) By storing the purge gas in the tank 300, the inside of the tank 300 can be heated by a large amount of molecules of the purge gas. Thereby, it is possible to effectively heat the extraneous material present at the cold spot (where the temperature is locally lowered due to any factor) inside the tank 300. As a result, it is possible to promote a phase change to the gas phase of the extraneous material in the tank, so that the adhesion of the particles to the wafer 200 can be further suppressed.

(b2) By exhausting the heated purge gas in the tank 300, it is possible to promote a phase change to the gas phase of an extraneous material downstream of the tank 300 (e.g., the gas supply pipe 232a, the process chamber 201, the inner walls of the exhaust pipes 301, 308, the valves 243a, 309 or their surroundings, the inside of the vacuum pump 246, etc.). Thus, film deposition at these sites or adhesion of particles to the wafer 200 can be suppressed.

(c) In step S621-2, the purge gas in the tank 300 is exhausted through a path that does not pass through a space in which the wafer 200 is disposed is not interposed in step S3. As a result, it is possible to suppress the adhesion of the extraneous material removed from within the tank 300 to the wafer 200 that is conveyed into the process chamber 201 and later loaded into the process chamber 201.

(d) In step S622-2, the purge gas in the tank 300 is exhausted through a path that pass through a space in which the wafer 200 is disposed in step S3. As a result, for example, the valves 243a and 305 or the extraneous materials of the first and second storage regions can be efficiently removed, so that adhesion of the extraneous material to the wafer 200 loaded into the process chamber 201 can be further suppressed.

(e) In these embodiments, step S621-1 and step S621-2 are performed a predetermined number of times, and then step S622-1 and step S622-2 are performed a predetermined number of times. Thereby, after the extraneous material in the tank 300 is removed, the heated purge gas can be supplied from the tank 300 toward the inside of the process chamber 201. Therefore, it is possible to remove the extraneous material on the valve 243a or the gas supply pipe 232a while making it difficult for the extraneous material removed from within the tank 300 to be transported into the process chamber 201. Further, it is preferable to perform step S622-1 and step S622-2 after performing step S621-1 and step S621-2 a plurality of times. This also makes it difficult for the extraneous material removed from within the tank 300 to be transported into the process chamber 201.

(f) The tank 300 preferably has a larger volume per unit length than the flow path (the gas supply pipe 232a in this embodiment) connected to the tank 300. This makes it easy to raise the partial pressure of the first process gas in the process chamber 201 within a short time because a larger amount of the first process gas can be stored in the reservoir. However, in this case, the first process gas is liable to remain inside the tank 300, and a cold spot is liable to be generated in the tank 300. Thus, the extraneous material is liable to occur inside the tank 300, and a smaller amount of the extraneous material is likely to be connected with particle generation. According to the present disclosure, even in this case, the internal extraneous material of the tank 300 can be effectively removed.

(g) In step S62, it is preferable that the temperature of the storage region be higher than a predetermined temperature. Thereby, it is possible to promote a phase change to the gas phase of the extraneous material in the tank 300 or in the flow path connected to the tank 300.

(h) In the supply region, movement of a large amount of gas toward the process chamber 201 in a short time in step S3, such as the tank 300 or the storage region, is difficult to occur. Therefore, the extraneous material in the supply region is more difficult to connect with particle generation than the extraneous material in the tank 300. Therefore, in step S62, it is preferable to make the temperature of the supply region lower than the temperature of the tank 300 or the storage region and suppress power consumption. Further, when the supply region is set to a high temperature, deterioration of the MFC 241a is promoted in some cases. From this, in step S62, the temperature of the supply region is preferably lower than the temperature of the tank 300 or the storage region.

(i) In step S621-1, at least a part of the flow path for supplying the purge gas into the tank 300 may be heated using, for example, the heater 324. Preferably, in step S621-1, at least a part of the flow path for supplying the purge gas into the tank 300 is heated to a temperature higher than the processing temperature. Thereby, the extraneous material in the storage region can be heated efficiently.

### Other Embodiments of the Disclosure

Embodiments of the present disclosure are described in detail above. However, the present disclosure is not limited to the above-described embodiments, but various changes can be made without departing from the gist thereof.

In the above-described embodiments, the case where the first purge process S621 and the second purge process S622 are sequentially performed as step S62 is taken as an example. However, the present disclosure is not limited thereto. In step S62, either of the first purge process S621 and the second purge process S622 may be omitted. Even in this case, at least some of the above-described effects can be obtained.

In the above-described embodiments, as step S62, the case where the purge gas is stored in the tank 300, such as the first purge process S621, or the second purge process S622, and the purge gas stored in the tank 300 is exhausted is given as an example. However, the present disclosure is not limited thereto. For example, in step S62, the purge gas in the tank 300 may be exhausted while supplying the purge gas into the tank 300 at a second temperature higher than the first temperature. Even in such a case, at least some of the above-described effects can be obtained.

In the above-described embodiments, in steps S621-1 and S621-2, the case where at least a part of the flow path for supplying the purge gas into the tank 300 is heated using the heater 324 is given as an example. However, the present disclosure is not limited thereto. The heater 324 may be omitted, and in step S621-1, a purge gas having a temperature lower than a predetermined temperature may be supplied in the storage region. Even in such a case, at least some of the above-described effects can be obtained. Further, in step S62, when the purge gas is stored in the tank 300 and the purge gas stored in the tank 300 is exhausted, and when the volume per unit length is larger compared with the flow path where the tank 300 is connected to the tank 300, the purge gas is liable to be heated in the tank 300. Therefore, the above-described effects are also easily obtained.

Further, in the above-described embodiments, the case where the first inert gas supply system and the second inert gas supply system are provided as the inert gas supply system in the gas supply pipe 232a is described, but the present disclosure is not limited thereto. A second inert gas supply system may be used as the first inert gas supply system. A third source 307, a gas supply pipe 232d, an MFC 241d, and a valve 243d may be used instead of the second source 306, the gas supply pipe 232c, the MFC 241c, and the valve 243c. Also in this modification, effects similar to those of the above-described embodiments and modifications are obtained.

Further, in the above-described embodiments, a case in which the first process gas supply system is purged in step S6 is described. However, it is not limited thereto, and the technology of the present disclosure can be similarly applied to the case where the second process gas supply system provided with the reservoir is purged. In addition, even when a gas supply system other than the example is purged as the first process gas or the second process gas, the technology of the present disclosure can be similarly applied.

In the above-described embodiments, an example in which an inert gas (i.e., a gas treated as not exhibiting reactivity such as N2 or a rare gas) is used as the purge gas is described. However, the purge gas may be a gas exhibiting a chemical action, for example, an oxidation gas or a reduction gas, which oxidizes or reduces a member or a gas in the surface of the wafer 200 or the process chamber 201. In addition, since the inert gas is often low in cost compared to a gas exhibiting a chemical action, the cost of processing can be reduced by using the inert gas as the purge gas.

In the above-described embodiments, an example in which a film is formed using a batch-type substrate processing apparatus that processes a plurality of substrates at a time is described. The present disclosure is not limited to the above-described embodiments and modifications, and can be suitably applied to, for example, a case where a film is formed using a single-wafer substrate processing apparatus that processes one or several substrates at a time. Further, in the above-described embodiments and modifications, an example in which a film is formed using a substrate processing apparatus with a hot-wall-type process furnace is described. The present disclosure is not limited to the above-described embodiments and modifications, and can be suitably applied to a case where a film is formed using a substrate processing apparatus with a cold-wall-type process furnace.

Even in the case where these substrate processing apparatuses are used, each process can be performed in the same processing procedure and processing conditions as in the above-described embodiments or modifications, and the same effects as in the above-described embodiments or modifications are obtained.

The above-described embodiments can be used in combination as appropriate. The processing procedure and the processing conditions at this time can be the same as the processing procedure and the processing conditions of the above-described embodiments or modifications, for example.

According to the present disclosure, adhesion of a foreign substance (a particle) to a substrate can be suppressed.

While certain embodiments are described, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
(a) performing:
(a1) storing a process gas obtained by phase-changing a substance in a liquid or solid phase in a reservoir (300) at a predetermined temperature; and
(a2) supplying the process gas stored in the reservoir (300) to the substrate (200); and
(b) after (a), performing:
(b1) supplying a purge gas into the reservoir (300) that is at a temperature higher than the predetermined temperature; and
(b2) exhausting the purge gas in the reservoir (300).

2. The method of Claim 1, wherein (b2) includes:
(b21) exhausting the purge gas in the reservoir (300) through a path that does not pass through a space in which the substrate (200) is disposed in (a).

3. The method of Claim 1 or 2, wherein (b2) includes:
(b22) exhausting the purge gas in the reservoir (300) through a path that passes through a space in which the substrate (200) is disposed in (a).

4. The method of any one of Claims 1 to 3, wherein (b2) includes:
(b21) exhausting the purge gas in the reservoir (300) through a path that does not pass through a space in which the substrate (200) is disposed in (a); and
(b22) exhausting the purge gas in the reservoir (300) through a path that passes through the space in which the substrate (200) is disposed in (a),
wherein in (b), (b1) and (b21) are performed a predetermined number of times, and then (b1) and (b22) are performed a predetermined number of times.

5. The method of any one of Claims 1 to 4, wherein the reservoir (300) has a larger volume per unit length than a flow path connected to the reservoir (300).

6. The method of any one of Claims 1 to 5, wherein in (b), a temperature of a storage region, which includes the reservoir (300) and in which the process gas is stored in (a), is set to be higher than the predetermined temperature.

7. The method of Claim 6, wherein in (b), a temperature of a supply region that supplies the process gas to the reservoir (300) is set to be lower than the temperature of the storage region.

8. The method of any one of Claims 1 to 7, wherein in (b), at least a part of a flow path that supplies the purge gas to the reservoir (300) is heated.

9. The method of any one of Claims 1 to 8, wherein in (b1), the purge gas having a temperature lower than the predetermined temperature is supplied into the reservoir (300).

10. The method of any one of Claims 1 to 9, wherein in (b1), the purge gas is stored in the reservoir (300), and
wherein in (b2), the purge gas stored in the reservoir (300) is exhausted.

11. A method of manufacturing a semiconductor device, comprising the method of Claim 1.

12. A program that causes, by a computer, a substrate processing apparatus to perform a process comprising:
(a) performing:
(a1) storing a process gas obtained by phase-changing a substance in a liquid or solid phase in a reservoir (300) at a predetermined temperature; and
(a2) supplying the process gas stored in the reservoir (300) to a substrate (200); and
(b) after (a), performing:
(b1) supplying a purge gas into the reservoir (300) that is at a temperature higher than the predetermined temperature; and
(b2) exhausting the purge gas in the reservoir (300).

13. A substrate processing apparatus, comprising:
a process chamber (201) in which a substrate (200) is disposed;
a reservoir (300) connected to a process gas source (301) that supplies a process gas obtained by phase-changing a substance in a liquid or solid phase, a purge gas source (306, 307) that supplies a purge gas, the process chamber (201), and an exhaust system (308, 309);
a process gas supply system (232a, 303, 241a, 304, 300, 243a) configured to control gas flow between the reservoir (300) and the process gas source (301), the purge gas source (306, 307), the process chamber (201), and the exhaust system (308, 309);
a first temperature control system (320) configured to control a temperature of the reservoir (300); and
a controller (121) configured to be capable of controlling the process gas supply system (232a, 303, 241a, 304, 300, 243a) and the first temperature control system (320) so that a process is performed, the process comprising:
(a) performing:
(a1) storing the process gas obtained by phase-changing the substance in the liquid or solid phase in the reservoir (300) at a predetermined temperature; and
(a2) supplying the process gas stored in the reservoir (300) to the substrate (200); and
(b) after (a), performing:
(b1) supplying the purge gas into the reservoir (300) that is at a temperature higher than the predetermined temperature; and
(b2) exhausting the purge gas in the reservoir (300).
